# EUROPEAN PATENT APPLICATION

(11) **EP 2 907 845 A1**
(43) Date of publication of application: **19.08.2015**
(21) Application number: 13844610.9
(22) Date of filing: 03.10.2013
(51) Int. Cl.: C08L 27/12, C08K 3/20, C08L 63/00, H01L 23/29, H01L 23/31, H01L 33/56

(54) **SEALANT COMPOSITION FOR ELECTRICAL AND ELECTRONIC PARTS, COATING MATERIAL FOR ELECTRICAL AND ELECTRONIC PARTS, AND LED DEVICE**

(30) Priority: 12.10.2012 JP 2012226906
(71) Applicant: CCS Inc., Kyoto-shi, Kyoto 602-8011 (JP)
(72) Inventor: ISOTANI, Masayuki, Kyoto-shi Kyoto 602-8011 (JP); DOHI, Kazuhiko, Kyoto-shi Kyoto 602-8011 (JP); USAMI, Jun, Kyoto-shi Kyoto 602-8011 (JP); MATSUKAWA, Teruki, Izumiotsu-shi Osaka 595-0019 (JP)
(74) Representative: Müller Hoffmann & Partner
(86) International application number: PCT/JP2013/076932
(87) International publication number: WO 2014/057858

(57) **Abstract**

An object is to provide a sealant composition for electrical and electronic parts that has excellent light resistance, heat resistance, heat shock resistance, and gas barrier properties, and an LED device using the same, and the composition contains a polyvalent metal compound containing a metallic element capable of having an ionic valance of 2 or more and a fluororesin including a functional group capable of forming a metal crosslink with the metallic element contained in the polyvalent metal compound.

## Description

### TECHNICAL FIELD

The present invention relates to a sealant composition for electrical and electronic parts and a coating agent for electrical and electronic parts that has excellent light resistance, heat resistance, heat shock resistance, and gas barrier properties, and an LED device using the same.

### BACKGROUND ART

Conventionally, epoxy resins and silicone resins have been used to seal LED chips in surface-mounted LED devices. However, epoxy resins are known to deteriorate over time as a result of discoloration caused by short wavelength radiation. In addition, epoxy resins do not have sufficient heat resistance, and heat generated by LED chips also contributes to the deterioration. In contrast, silicone resins are superior to epoxy resins in heat resistance and light resistance, and thus have now become predominant.

However, silicone resins, which have low gas barrier properties, allow moisture and a corrosive gas in the outside air to transmit therethrough, and therefore, have low effectiveness in preventing the deterioration over time of an object to be sealed. In view of this, silicone resins with improved gas barrier properties have been developed, but such silicone resins have poor light resistance despite their improved gas barrier properties. Further, silicone resins have poor adhesive strength, and in particular, are readily detached when subjected to a force applied in the shearing direction.

Meanwhile, methods of sealing LED chips with inorganic glass have also been investigated. However, it is necessary to perform heating at 200°C or higher in order to seal an LED chip with inorganic glass, and therefore, there are many problems, including, for example, the breakage of a sealed object containing the LED chip.

In contrast, fluororesins are known to have excellent light resistance, heat resistance, and gas barrier properties. Cited Document 1 discloses that a fluororesin is cured with a curing agent such as isocyanate, and used as a sealant for an LED chip and the like.

### CITATION LIST

### PATENT DOCUMENT

Patent Document 1: JP 2011-42762A

### SUMMARY OF INVENTION

### TECHNICAL PROBLEM

However, a fluororesin that has been cross-linked with a curing agent such as isocyanate tends to be as discolored by short wavelength radiation as epoxy resins and silicone resins.

The present invention has been made in view of such a problem, and it is a main intended task thereof to provide a sealant composition for electrical and electronic parts that has excellent light resistance, heat resistance, heat shock resistance, and gas barrier properties, and an LED device using the same.

### SOLUTION TO PROBLEM

That is, a sealant composition for electrical and electronic parts according to the present invention contains a polyvalent metal compound containing a metallic element capable of having an ionic valance of 2 or more, and a fluororesin including a functional group capable of forming a metal crosslink with the metallic element contained in the polyvalent metal compound.

Examples of the polyvalent metal compound include a compound containing at least one metallic element selected from the group consisting of Mg, Ca, Ba, Fe, Cu, Zn, Al, Ti, Si, and Zr.

Preferably, the sealant composition for electrical and electronic parts according to the present invention contains two or more of the polyvalent metal compounds.

The sealant composition for electrical and electronic parts according to the present invention may further contain an epoxy resin.

Electric and electronic products obtained by sealing electrical and electronic parts with the sealant composition for electrical and electronic parts according to the present invention also constitute one aspect of the present invention. Although the electrical and electronic parts are not particularly limited, the sealant composition for electrical and electronic parts according to the present invention is suitably used to seal an LED chip because it has excellent light resistance, heat resistance, heat shock resistance, and gas barrier properties.

An LED device obtained by sealing an LED chip with the sealant composition for electrical and electronic parts according to the present invention also constitutes one aspect of the present invention. That is, an LED device according to the present invention includes: an LED chip; and a sealing member that seals the LED chip, wherein the sealing member is obtained by curing the sealant composition for electrical and electronic parts according to the present invention.

The sealant composition for electrical and electronic parts according to the present invention is not easily discolored even by short wavelength visible radiation and ultraviolet radiation, and therefore, the LED device according to the present invention is effective especially when the LED chip emits visible radiation or ultraviolet radiation of a wavelength of 500 nm or less. Note that "visible radiation or ultraviolet radiation of a wavelength of 500 nm or less" specifically refers to blue light, purple light, near ultraviolet radiation, and ultraviolet radiation.

A coating agent for electrical and electronic parts according to the present invention contains a polyvalent metal compound containing a metallic element capable of having an ionic valance of 2 or more, and a fluororesin including a functional group capable of forming a metal crosslink with the metallic element contained in the polyvalent metal compound.

An LED device that uses a coating member including an LED coating agent according to the present invention also constitutes one aspect of the present invention. That is, an LED device according to the present invention includes: an LED chip; a substrate provided with a recess in which the LED chip is mounted; and a coating member that coats an inner peripheral surface of the recess, wherein the coating member is obtained by curing the coating agent for electrical and electronic parts according to the present invention.

Furthermore, examples of the LED device according to the present invention include an LED device including: an LED chip; a substrate provided with a recess in which the LED chip is mounted; and a coating member that coats a side peripheral surface of the substrate, wherein the coating member is obtained by curing the coating agent for electrical and electronic parts according to the present invention.

### ADVANTAGEOUS EFFECTS OF INVENTION

According to the present invention having such a configuration, it is possible to obtain a sealant composition for electrical and electronic parts and an LED coating agent that have excellent light resistance, heat resistance, heat shock resistance, and gas barrier properties, and that are not easily discolored even by short wavelength visible radiation or ultraviolet radiation, and an LED device using the same.

### BRIEF DESCRIPTION OF DRAWINGS

FIG. 1 is a partial vertical cross-sectional view showing an LED device according to a first embodiment of the present invention.
FIG. 2 is a plan view showing the LED device according to the first embodiment.
FIG. 3 is a plan view showing an LED device according to a second embodiment.
FIG. 4 is a cross-sectional view showing the LED device according to the second embodiment, taken along a line AA
FIG. 5 is an enlarged cross-sectional view showing a portion indicated by an enclosing line B of the LED device according to the second embodiment.
FIG. 6 is a partial vertical cross-sectional view showing an LED device according to a third embodiment.
FIG. 7 shows images of an LED device before testing.
FIG. 8 shows images of an LED devices using Sample 4 after testing.
FIG. 9 shows images of an LED device using Sample 5 after testing.

### REFERENCE CHARACTER LIST

- 1: LED device
- 2: Substrate
- 3: LED chip
- 4: Sealing member

### DESCRIPTION OF EMBODIMENTS

Hereinafter, the present invention will be described in detail.

A sealant composition for electrical and electronic parts according to the present invention contains a polyvalent metal compound and a fluororesin.

The polyvalent metal compound is a polyvalent metal compound containing a metallic element capable of having an ionic valance of 2 or more, more preferably, 2 to 4, and examples thereof include a compound containing a metallic element classified as a typical metal or an amphoteric metal such as Mg, Ca, Ba, Fe, Cu, Zn, Al, Ti, Si, or Zr. An oxide can be suitably used as such a polyvalent metal compound. These polyvalent metal compounds may be used alone or in a combination of two or more. Furthermore, the use of a compound containing a transition metal as the polyvalent metal compound can increase variations of metal crosslinks.

The fluororesin includes a functional group capable of forming a metal crosslink with the metallic element contained in the polyvalent metal compound. A metal crosslink is a structure that connects resin molecules with an ionic bond via metal. Such a metal crosslink has excellent light resistance because it is less susceptible to the influence of light than a cross-linked structure formed by a covalent bond that is formed in a fluororesin cured with a curing agent such as isocyanate. Although structures that connect resin molecules via metal also include a structure formed by a coordinate bond, a coordinate bond is inferior to an ionic bond with respect to light resistance because it is as susceptible to the influence of light as a covalent bond. Examples of the functional group capable of forming a metal crosslink include a hydroxyl group and a carboxyl group. Note that the carboxyl group may be an acid anhydride group.

The fluororesin including such a functional group is not particularly limited, and examples thereof include vinyl-based polymers such as a copolymer of fluoroolefin, vinyl ether, and a monomer including the functional group; a copolymer of fluoroolefin, vinyl ester, and a monomer including the functional group; a copolymer of tetrafluoroethylene, a hydrocarbon-based monomer, vinyl ester, and a monomer including the functional group; and a copolymer of vinylidene fluoride and a monomer including the functional group. Note that a copolymer of vinylidene fluoride and a monomer including the functional group may contain a hydrocarbon-based monomer, vinyl ether, vinyl ester, or the like as a constituent unit, as needed.

Examples of the above-described fluoroolefin include tetrafluoroethylene, hexafluoropropylene, perfluoro(alkylvinylether), trifluoroethylene, vinylidene fluoride, and ethylene fluoride.

Examples of the above-described vinyl ether include methyl vinyl ether, ethyl vinyl ether, n-butyl vinyl ether, isobutyl vinyl ether, 2-ethylhexyl vinyl ether, cyclohexyl vinyl ether, and 2-methoxyethyl vinyl ether.

Examples of the above-described vinyl ester include vinyl versatate, vinyl benzoate, p-t-butyl vinyl benzoate, vinyl acetate, vinyl propionate, vinyl butyrate, vinyl pivalate, and vinyl caproate.

Examples of the above-described hydrocarbon-based monomer include ethylene, propylene, isobutylene, butylene, pentene, hexene, heptene, and octene.

Examples of the monomer including a hydroxyl group as the functional group include hydroxyalkyl vinyl ethers such as hydroxyethyl vinyl ether, hydroxy propyl vinyl ether, and hydroxy butyl vinyl ether; hydroxyalkyl allyl ethers such as 2-hydroxyethyl allyl ether, and 4-hydroxybutyl allyl ether; N-methylol(meth)acrylamide such as N-methylol acrylamide; and hydroxyalkyl(meth)acrylate such as hydroxyethyl(meth)acrylate.

Examples of the monomer including a carboxyl group as the functional group include acrylic acid, methacrylic acid, vinyl acetic acid, crotonic acid, maleic acid, a maleic acid monoester, maleic acid anhydride, fumaric acid, and a fumaric acid monoester.

The content of the polyvalent metal compound is preferably 0.2 to 2.0 equivalents, more preferably 0.4 to 1.5 equivalents, per equivalent of the functional group. If it is less than 0.2 equivalents, curing cannot be performed sufficiently. If it exceeds 2.0 equivalents, water resistance is reduced by an excessive metal content.

As described above, the sealant composition for electrical and electronic parts according to the present invention may contain two or more of the polyvalent metal compounds. When the LED chip is sealed with a composition containing two or more of the polyvalent metal compounds, a density gradient is created in the vertical direction within the sealing member according to the atomic weight difference between the metallic elements, and the density is larger in the lower part of the sealing member and smaller in the upper part thereof. Since the density and the refractive index are correlated, the refractive index is larger in the lower part where the density is larger and is smaller in the upper part where the density is smaller, and a refractive index gradient can be formed in the vertical direction within the sealing member. There is no boundary in the thus-formed refractive index gradient within the sealing member, and the refractive index continuously changes. Accordingly, it can be expected that light passing through the inside of the sealing member will not undergo total reflection in the course of passage. Furthermore, if the refractive index on the surface of the sealing member that is in contact with the outside air is caused to approach 1, it is also possible to prevent total reflection on this interface. Therefore, by sealing the LED chip with a composition containing two or more of the polyvalent metal compounds, obtainment of an LED device that is highly efficient in extracting light from the LED chip can be expected.

Apart from the use of two or more of the polyvalent metal compounds, such adjustment of the density and the associated adjustment of the refractive index can also be achieved by the use of two or more fluororesins having different ratios of the incorporated functional groups, or by application of a magnetic force by adding a magnetic substance to the fluororesin.

The sealant composition for electrical and electronic parts according to the present invention may contain an epoxy resin within a range that does not impair the properties of the present invention. Epoxy resins have excellent gas barrier properties and are more advantageous in terms of costs than fluororesins although their light resistance, heat resistance and heat shock resistance properties are deficient. For this reason, when a fluororesin and an epoxy resin are used as a mixture, the light resistance, heat resistance and heat shock resistance properties, in which the epoxy resin is deficient, are compensated for by those of the fluororesin. Accordingly, it is possible to obtain a sealant composition for electrical and electronic parts that is excellent in light resistance, heat resistance, heat shock resistance, and gas barrier properties, while saving in cost.

When the sealant composition for electrical and electronic parts according to the present invention contains an epoxy resin, the content thereof is preferably 0 to 50 wt%, more preferably 0 to 30 wt%, based on the fluororesin. If the content exceeds 50 wt%, discoloration becomes prominent.

In terms of the processability during sealing of an LED chip or the like, the sealant composition for electrical and electronic parts according to the present invention preferably has a moderate fluidity at room temperature (25°C), and may contain a solvent in order to provide such a fluidity.

The solvent is not particularly limited, and examples thereof include methyl acetate, butyl acetate, xylene, and toluene.

A content of the solvent is not particularly limited, but is preferably 5 to 60 wt%, more preferably 10 to 30 wt%, based on a total amount of the sealant composition for electrical and electronic parts according to the present invention, for example. When the content of the solvent is less than 5 wt%, a moderate fluidity cannot be achieved. However, if it exceeds 60 wt%, it takes time to volatilize the solvent to cure the sealant composition for electrical and electronic parts according to the present invention.

Further, the viscosity (25°C) of the sealant composition for electrical and electronic parts according to the present invention is preferably 200 to 20,000 mPa ·s, more preferably 200 to 15,000 mPa ·s.

Within the range that does not impair the effects of the present invention, the sealant composition for electrical and electronic parts according to the present invention may further contain various additives, including, for example, other resins, a polymerization initiator such as a radical polymerization initiator, an antioxidant, an ultraviolet radiation absorbent, a filler, a plasticizer, an antistatic agent, a surfactant, a lubricant, a film-thickness increasing agent, a colorant, a conductive agent, a release agent, a flow control agent, a flame retardant, an antifoaming agent, a leveling agent, an ion adsorbent, a surface treating agent, and a reactive diluent. Furthermore, when the sealant composition for electrical and electronic parts according to the present invention is used to seal the LED chip, it may contain a reflector, a fluorescent, and the like.

The sum of the contents of the various additives is preferably 15 wt% or less, more preferably 5 wt% or less, based on the total amount of the sealant composition for electrical and electronic parts according to the present invention, excluding the solvent.

In order for the sealant composition for electrical and electronic parts according to the present invention to be cured, the sealant composition may be heated at 90 to 160°C for about 0.5 to 24 hours. This makes it possible to volatilize the solvent to cause the sealant composition to lose its fluidity and be cured.

While electrical and electronic parts that are to be sealed by the sealant composition for electrical and electronic parts according to the present invention are not particularly limited, the sealant composition is suitably used to seal an LED chip, for example. An LED device obtained by sealing an LED chip with such a sealant composition for electrical and electronic parts according to the present invention also constitutes one aspect of the present invention.

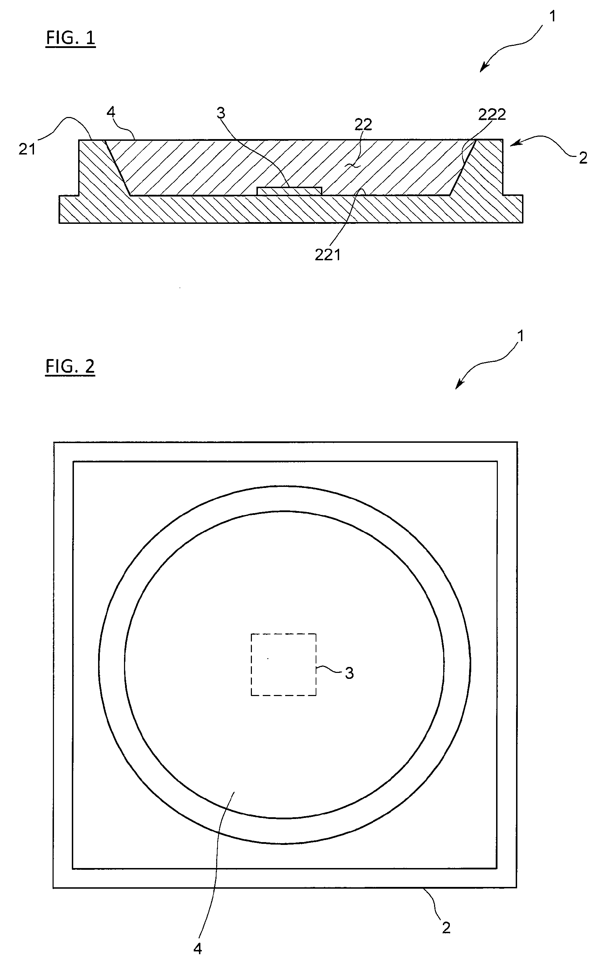

An LED device according to a first embodiment of the present invention is illustrated in FIGS. 1 and 2.

An LED device 1 of the first embodiment illustrated in FIGS. 1 and 2 includes a substrate 2 having a recess 22 that is open at an upper end surface 21, an LED chip 3 mounted on a bottom surface 221 of the recess 22, a sealing member 4 that is made of the sealant composition for electrical and electronic parts according to the present invention and that seals the LED chip 3.

A detailed description will now be given of each of the components.

The substrate 2 has the recess 22 that is open at the upper end surface 21, and an example thereof is a substrate obtained by molding an insulating material having a high thermal conductivity such as alumina or aluminum nitride.

The substrate 2 is configured to mount the LED chip 3, which will be described later, on the bottom surface 221 of the recess 22, and a wiring conductor (not shown) to which the LED chip 3 is to be electrically connected is formed on the bottom surface 221. This wiring conductor is drawn to the outer surface of the LED device 1 via a wiring layer (not shown) formed inside the substrate 2, and connected to an external electric circuit board, and thereby, the LED chip 3 and the external electric circuit board are electrically connected.

A high-reflectance metal thin film is formed on the inner surface including a side surface 222 and the bottom surface 221 of the recess 22 of the substrate 2 by providing, for example, metal plating such as silver, aluminum, or gold, and functions as a reflector.

The LED chip 3 is formed, for example, by laminating an n-type layer, a light-emitting layer, and a p-type layer of a gallium nitride-based compound semiconductor in this order on a sapphire substrate, and such an LED chip 3 emits blue light, purple light, and ultraviolet radiation.

The LED chip 3 is flip-chip mounted to the bottom surface 221 of the recess 22 by using solder bumps, gold bumps, or the like (not shown), with the gallium nitride-based compound semiconductor facing down (toward the bottom surface 221 of the recess 22).

The sealing member 4 is filled in the recess 22 to seal the LED chip 3, and is obtained by curing the sealant composition for electrical and electronic parts according to the present invention.

With such an LED device 1 according to the present embodiment, the sealing member 4 obtained by curing the sealant composition for electrical and electronic parts according to the present invention has excellent gas barrier properties, and it is therefore possible to suppress sulfuration of silver when a metal thin film made of silver is formed on the inner surface of the recess 22 of the substrate 2. When the sealing member 4 is composed of a composition containing two or more polyvalent metal compounds and has a refractive index that continuously changes, it is possible to achieve high efficiency in extracting light from the LED chip 3. Since the fluororesin is metal cross-linked in the sealing member 4, the LED chip 3 does not easily discolor or deteriorate even if it emits blue light, purple light, and ultraviolet radiation.

Next is a description of a coating agent for electrical and electronic parts according to the present invention.

The coating agent for electrical and electronic parts according to the present invention is similar to the above-described sealant composition for electrical and electronic parts, and contains a polyvalent metal compound and a fluororesin. The compositions and the like of the polyvalent metal compound and the fluororesin are the same as those described above, and therefore, the description thereof has been omitted here.

In the case of using the coating agent for electrical and electronic parts according to the present embodiment, the coating agent for electrical and electronic parts according to the present embodiment may contain a surfactant, an organic solvent, a silane coupling agent, and the like within a range that does not impair the effects of the present invention.

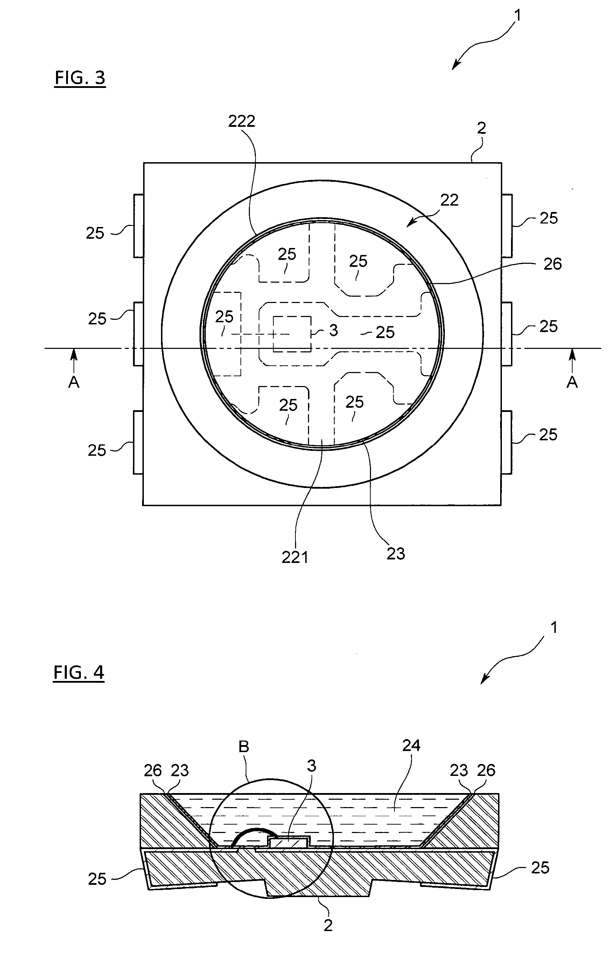

A second embodiment and a third embodiment of an LED device using the coating agent for electrical and electronic parts according to the present invention are illustrated in FIGS. 3, 4, 5 and 6. Note that the portions that are identical to those of the LED device 1 of the first embodiment are denoted by identical reference numerals, and the descriptions thereof have been omitted.

The LED device 1 of the second embodiment illustrated in FIGS. 3 and 4 includes a substrate 2, an LED chip 3, a coating layer 23 that is made of the coating agent for electrical and electronic parts according to the present invention and that coats a bottom surface 221 and a side surface 222 of a recess 22 of the substrate 2, and a sealing member 24 that is laminated on the coating layer 23 to seal the LED chip 3.

The substrate 2 is configured to mount the LED chip 3 on the bottom surface 221 of the recess 22, and a wiring pattern 25 to which the LED chip 3 is to be electrically connected is formed on the bottom surface 221. The wiring pattern 25 is molded on the bottom surface 221 of the recess 22 of the substrate 2, and is electrically connected to an external electric circuit board, which is not shown.

A high-reflectance metal thin film 26 is formed on the side surface 222 of the recess 22 of the substrate 2 by providing, for example, metal plating such as silver, aluminum, or gold, and functions as a reflector.

By being electrically connected to the wiring pattern 25, the LED chip 3 is electrically connected to the external electric circuit board via the wiring pattern 25.

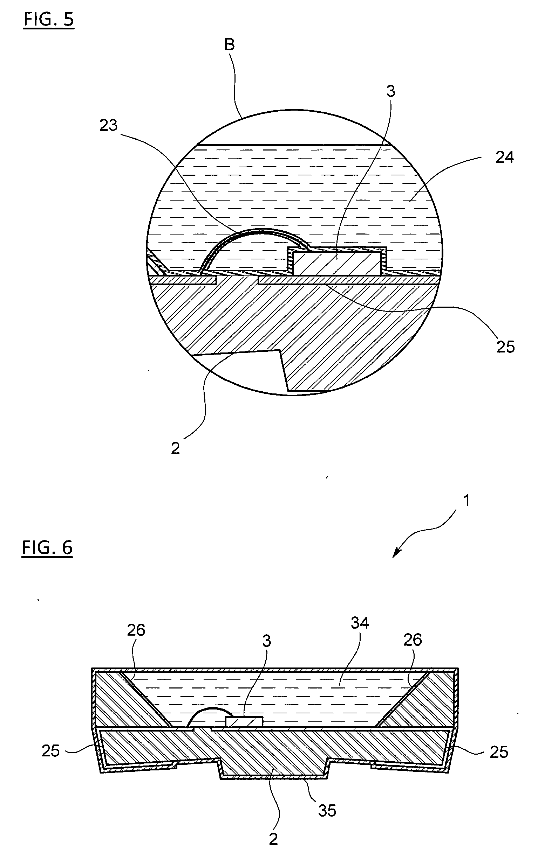

As shown in FIG. 5, the coating layer 23 covers the wiring pattern 25 provided on the bottom surface 221 of the recess 22 of the substrate 2 and the LED chip 3, and also covers the metal thin film 26 provided on the side surface 222 of the recess 22 of the substrate 2. Note that the coating layer 23 may be configured to cover the LED chip 3 and the metal thin film 26, or to cover the metal thin film 26.

The sealing member 24 is filled in the recess 22 so as to be laminated onto the coating layer 23 to seal the LED chip 3, and a sealing member obtained by curing a sealant made of a transparent silicone resin can be used, for example.

With the LED device according to the second embodiment, the coating layer 23 obtained by curing the LED coating agent has excellent gas barrier properties, and it is therefore possible, with the coating layer 23, to suppress discoloration caused by the wiring pattern 25 and the metal thin film 26 provided on the substrate 2 reacting with a gas even if the gas flows in through the sealing member 24.

The LED device 1 of the third embodiment illustrated in FIG. 6 includes a substrate 2, an LED chip 3, a sealing member 34 that seals the LED chip 3, and a coating layer 35 that is made of the coating agent for electrical and electronic parts according to the present invention and that coats the substrate 2 so as to cover at least a side peripheral surface thereof.

The sealing member 34 is filled in the recess 22 to seal the LED chip 3, and a sealing member obtained by curing a sealant made of a transparent silicone resin can be used, for example.

The coating layer 35 covers the outer peripheral surface of the substrate 2 and the sealing member 34 that seals the recess 22 provided in the substrate 2.

In the LED device 1 according to the third embodiment as well, the coating layer 35 obtained by curing the coating agent for electrical and electronic parts has excellent gas barrier properties, and it is therefore possible to prevent a gas from flowing into the coating layer 35, and suppress discoloration caused by the wiring pattern 25 and the metal thin film 26 provided on the substrate 2 reacting with the gas.

It should be appreciated that the present invention is not limited to the above-described embodiment, and various modifications may be made without departing from the gist of the present invention.

### Examples

In the following, the present invention will be described in further detail by way of examples, but the present invention is not limited to these examples.

### <Test 1>

Samples 1 to 3 with the compositions shown in Table 1 below were prepared as LED sealant compositions to be tested. The ingredients shown in Table 1 are as follows. The numerical values of the ingredients represent parts by mass, and "-" indicates that the relevant ingredient is not blended. Note that the LED sealant compositions further contain butyl acetate as an organic solvent, and the nonvolatile content NV is approximately 55 mass%.
- Fluororesin A: ZEFFLE GK-510 (manufactured by Daikin Industries, Ltd.)
- Fluororesin A (metal cross-linked): obtained by cross-linking ZEFFLE GK-510 (manufactured by Daikin Industries, Ltd.) with zinc oxide
- Fluororesin B: ZEFFLE GK-570 (manufactured by Daikin Industries, Ltd.)
- Blocked isocyanate: DURANATE TPA-B80X (manufactured by ASAHI KASEI CHEMICALS)

Using each of the obtained LED sealant compositions of Samples 1 to 3, an LED chip having a radiation peak at 405 nm was sealed, and preheated at 65 °C for one hour, then heated at 150°C for three hours, to cure the LED sealant composition of the sample.

The following evaluation was made for the sealing portions of the obtained LED devices. The results of the evaluation are shown in Table 1 below.

### <Aging Test>

Each of the obtained LED devices was lit at 25°C with an IF of 120 mA, and aged for 64 hours. The change in color of the sealing portion before and after the aging was evaluated by visual inspection. In Table 1, "○" indicates that discoloration has not occurred, and "×" indicates that discoloration has occurred.

### <Thermal Shock Resistance Test>

Alternate immersion in ice water (0°C) and boiling water (100°C) for one minute each was taken as one cycle. This cycle was repeated 100 times, and the change in color of the sealing portion was observed. In Table 1, "○" indicates that the sample endured thermal shock (no change was observed in the sealing portion), and "×" indicates that the sample did not endure thermal shock (a change was observed in the sealing portion).

**[Table 1]**

| Sample No. | | 1 | 2 | 3 |
|---|---|---|---|---|
| Composition | Fluororesin A (metal cross-linked) | 100 | - | - |
| | Fluororesin A | - | 100 | - |
| | Fluororesin B | - | - | 100 |
| | Blocked isocyanate | - | - | 20 |
| Type of crosslink | | Metal crosslink | No crosslink | Urethane crosslink |
| Aging test | | ○ | ○ | × |
| Thermal shock resistance test | | ○ | × | ○ |

As shown in Table 1, discoloration due to the 64-hour aging was observed in the sealing portion using Sample 3. The reason seems to be that discoloration occurred as a result of cleavage of the urethane cross-linked portion derived from isocyanate caused by ultraviolet radiation from the LED chip.

In contrast, as shown in Table 1, Samples 1 and 2 did not undergo discoloration due to 64-hour aging, both as a whole and on the chip.

However, Sample 2 did not endure thermal shock because it had not been subjected to a cross-linking treatment.

On the other hand, it seems that the metal crosslink of Sample 1 is formed by an ionic bond and is therefore less susceptible to the influences of light and heat, as compared with a cross-linked structure formed by a covalent bond such as a urethane bond.

### <Test 2>

Next, Samples 4 and 5 were prepared as LED sealant compositions to be tested.

Sample 4 was made of a silicone resin, and Sample 5 was obtained by cross-linking a fluororesin with metal.

Using each of the obtained LED sealant compositions of Samples 4 and 5, a recess having a wiring pattern formed on its bottom surface was sealed, and preheated at 65°C for one hour, then heated at 150°C for 3 hours, to cure the LED sealant composition of the sample.

Then, a corrosive gas test was conducted on the sealing portions of the obtained LED devices in accordance with the following procedure.

Each of the obtained LED devices was left standing for 48 hours under an environment of 2.0 ppm of H₂S, a temperature of 40°C, and a relative humidity of 90% RH, and the degree of discoloration before and after the standing of the metal wiring pattern disposed on the bottom surface of the recess was evaluated by visual inspection.

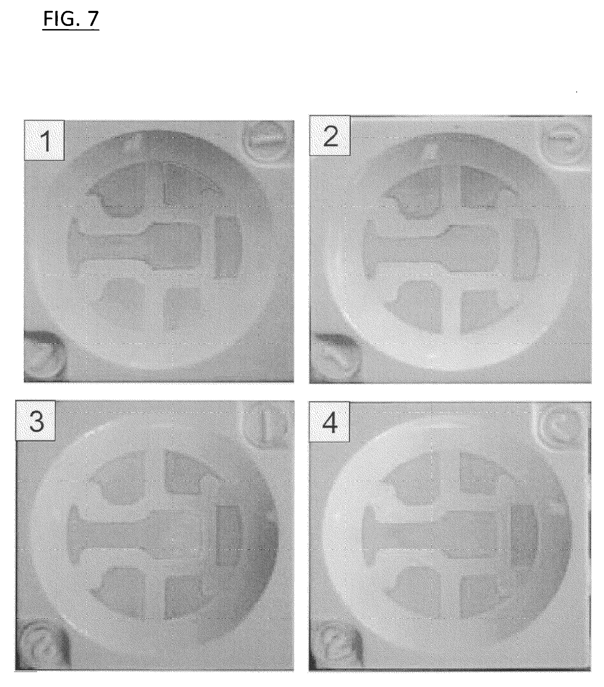

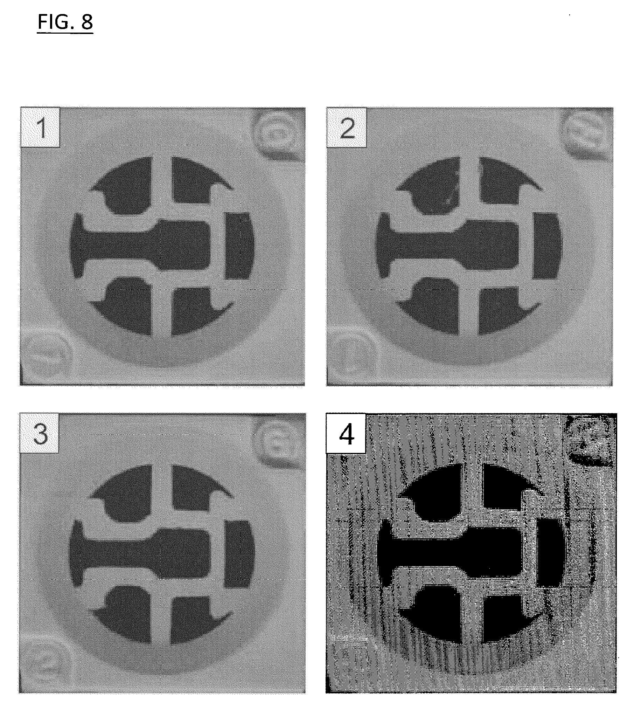

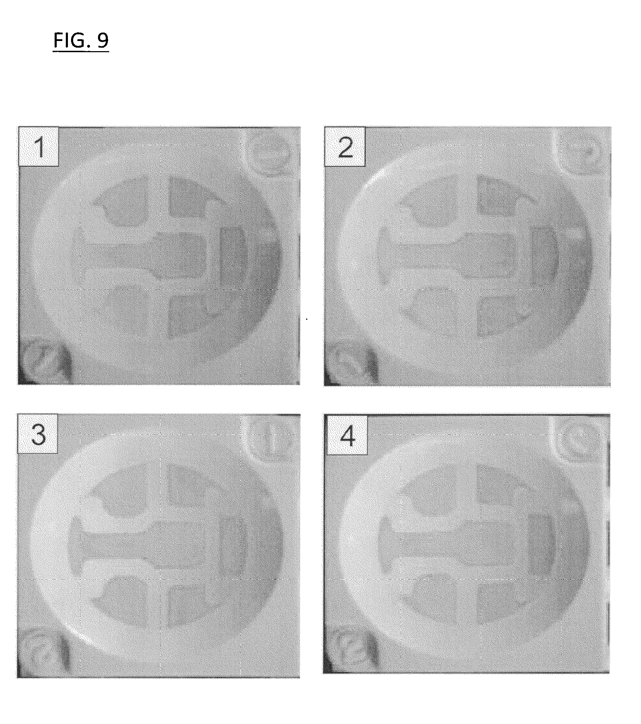

FIGS. 7 to 9 show images representing the LED devices before and after the corrosive gas test. Here, FIG. 7 shows images of an LED device before testing, FIG. 8 shows images of the LED device using Sample 4 after testing, and FIG. 9 shows images of the LED device using Sample 5 after testing.

Note that in FIG. 7, images obtained by capturing images of Sample 5 were used as images of the LED device before testing. The states before testing of Samples 4 and 5 are the same, and therefore, the captured images of one of the samples were used as images representing the states before testing.

As shown in FIGS. 7 and 8, in the case of the LED device using Sample 4 as the sealing portion, the metal wiring pattern was discolored into black after the end of the corrosive gas test, as compared with the state before testing. On the other hand, as shown in FIGS. 7 and 9, in the case of the LED device using Sample 5 as the sealing portion, the metal wiring pattern showed substantially no discoloration as compared with the state before testing.

The following two factors are considered to have caused the discoloration of the metal wiring pattern.

The first factor is that the generation of heat in the LED device results in a gap between the metal wiring pattern and the substrate or the sealing portion due to a difference in coefficients of linear expansion between the metal wiring pattern provided on the bottom surface of the recess and the resin constituting the substrate of the LED or the resin used in the sealing portion that seals the LED, and a H₂S gas flowed in from this gap, thus causing the sulfuration and the black discoloration of the metal wiring pattern.

The second factor seems to be that the H₂S gas that passed through the sealing portion caused the sulfuration and the black discoloration of the metal wiring pattern.

Here, in the case of the LED device using the silicone resin of Sample 4 as the sealing portion, it seems that the generation of a gap between the metal wiring pattern and the resin due to the difference in coefficients of linear expansion was prevented because of a relatively low degree of hardness of the silicone resin, but a H₂S gas passed through the sealing portion because of low gas barrier properties of the silicone resin, causing the sulfuration and the black discoloration of the metal wiring pattern.

On the other hand, in the case of the LED device using the fluororesin of Sample 5 as the sealing portion, it seems that the generation of a gap between the metal wiring pattern and the resin was prevented and the passage of a H₂S gas through the sealing portion was also prevented because the gas barrier properties of the fluororesin are higher than those of the silicone resin, making it possible to prevent the sulfuration of the metal wiring pattern.

### Industrial Applicability

According to the present invention, it is possible to obtain a sealant composition for electrical and electronic parts and an LED coating agent that have excellent light resistance, heat resistance, heat shock resistance, and gas barrier properties, and that are not easily discolored even by short wavelength visible radiation or ultraviolet radiation, and an LED device using the same.

## Claims

1. A sealant composition for electrical and electronic parts, containing
a polyvalent metal compound containing a metallic element capable of having an ionic valance of 2 or more, and a fluororesin including a functional group capable of forming a metal crosslink with the metallic element contained in the polyvalent metal compound.

2. The sealant composition for electrical and electronic parts according to claim 1,
wherein the polyvalent metal compound is a compound containing at least one metallic element selected from the group consisting of Mg, Ca, Ba, Fe, Cu, Zn, Al, Ti, Si, and Zr.

3. The sealant composition for electrical and electronic parts according to claim 1, containing two or more types of the polyvalent metal compound.

4. The sealant composition for electrical and electronic parts according to claim 1, containing an epoxy resin.

5. An LED device comprising:
an LED chip; and
a sealing member that seals the LED chip,
wherein the sealing member is obtained by curing the composition according to claim.

6. The LED device according to claim 5,
wherein the LED chip emits visible radiation or ultraviolet radiation of a wavelength of 500 nm or less.

7. A coating agent for electrical and electronic parts, containing
a polyvalent metal compound containing a metallic element capable of having an ionic valance of 2 or more, and a fluororesin including a functional group capable of forming a metal crosslink with the metallic element contained in the polyvalent metal compound.

8. An LED device comprising:
an LED chip;
a substrate provided with a recess in which the LED chip is mounted; and
a coating layer that coats an inner peripheral surface of the recess,
wherein the coating layer is obtained by curing the coating agent according to claim 7.

9. An LED device comprising:
an LED chip;
a substrate provided with a recess in which the LED chip is mounted; and
a coating layer that coats a side peripheral surface of the substrate,
wherein the coating layer is obtained by curing the coating agent according to claim 7.
